Europäisches Patentamt

European Patent Office

Office européen des brevets

(11) Veröffentlichungsnummer: **0 472 766 A1**

## EUROPÄISCHE PATENTANMELDUNG

(21) Anmeldenummer: **90116686.8**

(22) Anmeldetag: **30.08.90**

(51) Int. Cl.5: **H01L 23/31**, H01L 23/495

(43) Veröffentlichungstag der Anmeldung:
**04.03.92 Bulletin 92/10**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Franz, Karl-Heinz, Ing. (FH)**
**Stiftsbogen 148**
**W-8000 München(DE)**
Erfinder: **Beer, Gottfried, Ing. (FH)**
**Waldstrasse 2**
**W-8411 Etterzhausen(DE)**
Erfinder: **Scheuenpflug, Richard, Ing. (FH)**
**Mariaorter Strasse 25**
**W-8411 Kleinprüfening(DE)**

(54) Verfahren zum Abdecken eines kontaktierten Halbleiterchips.

(57) Ein Verfahren zum Abdecken eines kontaktierten und auf einem mit einer Leiterbahnstruktur (4) versehenen Kunststoffträgerband (5) befestigten Halbleiterchips (3), bei dem der Halbleiterchip (3) mit seinen Kontaktverbindungen (6) mit einem Tropfen aus aushärtbarem Kunststoff kalottenförmig vergossen wird, soll die Reproduzierbarkeit der Kalottenform gewährleisten. Das Kunststoffträgerband (5) wird vor dem Vergießen mit einem den Halbleiterchip (5) und dessen Kontaktverbindungen (6) ringförmig umschließenden Fließstopp (2) versehen.

Das erfindungsgemäße Verfahren findet insbesondere beim Herstellen von Chipmodulen für Chipkarten Anwendung.

Die Erfindung betrifft ein Verfahren zum Abdekken eines kontaktierten und auf einem mit einer Leiterbahnstruktur versehenen Kunststoffträgerband befestigten Halbleiterchips, bei dem der Halbleiterchip mit seinen Kontaktverbindungen mit einem Tropfen aus aushärtbarem Kunststoff kalottenförmig vergossen wird.

Es ist bekannt, bereits kontaktierte Halbleiterchips mit einer Schutzabdeckung zu versehen. Zu diesem Zweck wird beispielsweise ein Tropfen aus einem aushärtbaren Kunststoff auf den Halbleiterchip aufgebracht.

Ein solches bekanntes Verfahren wird beispielsweise zum Herstellen von Chipmodulen verwendet, die für Chipkarten benötigt werden. Die Halbleiterchips werden dabei auf einem Kunststoffträgerband beispielsweise durch Kleben befestigt und gebondet, d.h. die Kontaktflächen der Chips sind schon z.B. mittels Goldkontakverbindungen mit den auf dem Trägerband befindlichen Leiterbahnen verbunden, die beispielsweise aus Kupfer bestehen. Der bereits kontaktierte Halbleiterchip wird dann mit einer kalottenförmigen Schutzschicht bzw. Abdeckung versehen, die beispielsweise in Form eines Geltropfens auf den Halbleiterchip aufgebracht wird. Diese Schutzabdeckung umschließt auch die als Kontaktverbindungen am Halbleiterchip angebrachten Golddrähte.

Beim tropfenförmigen Aufbringen der Abdeckbzw. Vergußmasse auf einen Halbleiterchip besteht das Problem, daß die Tropfenform durch Verfließen nur schwer reproduzierbar ist. Dieses Problem ist insbesondere dann gravierend, wenn ein solcher Chipmodul in Gehäuse eingebaut werden soll, die genormt sind bzw. genau vorgeschriebene Abmessungen haben. Ein solches Gehäuse stellt eine Chipkarte dar. Unter einer Chipkarte versteht man eine Kunststoff-bzw. Plastikkarte im Format beispielsweise der bekannten Scheckkarte, in die integrierte elektronische Mikroschaltkreise implantiert sind. So ist beispielsweise ein Chipmodul in einer vorgegebenen Position in einer solchen genormten Karte implantiert, dessen Konturen mit den Konturen auf der vorgegebenen Stelle auf der Chipkarte möglichst übereinstimmen sollten.

Um dem Problem des Verfließens des Abdecktropfens beizukommen, hat man bereits aufwendige Formstempel verwendet. Dabei tritt u. a. allerdings ein nachteiliges Fädenziehen auf. Eine andere Möglichkeit, die Reproduzierbarkeit der Form der Abdeckung zu verbessern, besteht in der allerdings relativ aufwendigen Verwendung hochthixotroper Vergußmassen. Auch durch die Verwendung eines UV-Gels mit entsprechender Steuerung kann die Reproduzierbarkeit ebenfalls verbessert werden. Allerdings müssen auch hier ein relativ hohes Investment, lange Taktzeiten und teilweise kaum akzeptable chemische Randbedingungen in Kauf genommen werden.

Der Erfindung liegt die Aufgabe zugrunde, diese Nachteile zu vermeiden und ein Verfahren zum kalottenförmigen Abdecken eines bereits kontaktierten Halbleiterchips zu schaffen, das die Reproduzierbarkeit der Kalottenform der Abdeckung gewährleistet und das damit insbesondere zur Herstellung von Chipkartenmodulen geeignet ist.

Diese Aufgabe wird bei einem Verfahren der eingangs genannten Art erfindungsgemäß dadurch gelöst, daß das Kunststoffträgerband vor dem Vergießen mit einem den Halbleiterchip und dessen Kontaktverbindungen ringförmig umschließenden Fließstopp versehen wird.

Der Fließstopp wird dabei vorzugsweise durch Laserabbrand gebildet. Der Fließstopp wird zweckmäßig in Gestalt einer ringförmigen Vertiefung in das Kunststoffträgerband eingebracht, und zwar mittels einer Laserstrahlung. Als Strahlungsquelle wird beispielsweise ein Gaslaser, vorzugsweise ein $CO_2$-Laser verwendet. Als Material für das Kunststoffträgerband ist ein Polyester besonders geeignet.

Die mit der Erfindung erzielten Vorteile bestehen insbesondere darin, daß auf einfache Weise, nämlich durch definierte Stellen erhöhter Oberflächenspannung auf dem Kunststoffträgerband, die zur Chip- und Chipkontaktabdeckung verwendete Vergußmasse lokal exakt gestoppt werden kann. Damit ist die Reproduzierbarkeit der Kalottenform der Schutzabdeckung des Halbleiterchips und dessen Zuleitungen gewährleistet. Aufgrund dieser Reproduzierbarkeit der Form der Abdeckung ist das erfindungsgemäße Verfahren zum Herstellen von Chipmodulen für Chip- bzw. Wertkarten besonders geeignet.

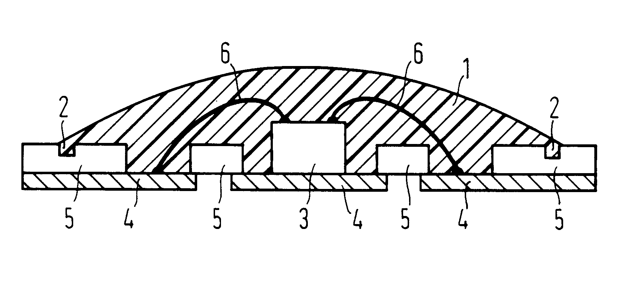

Anhand eines in der Figur der Zeichnung dargestellten Ausführungsbeispiels wird die Erfindung im folgenden näher erläutert.

In der Figur ist ein nach dem erfindungsgemäßen Verfahren hergestellter Chipkarten-Modul schematisch im Schnitt dargestellt. Der Halbleiterchip 3, beispielsweise ein EEPROM, ist auf einem mit einer Leiterbahnstruktur 4 versehenen Kunststoffträgerband 5 befestigt. Das Kunststoffträgerband 5 besteht aus einem Polyester. Der Halbleiterchip 3 ist mit seinen Kontaktverbindungen 6, in diesem Beispiel mit den durch das Kunststoff-Trägerband 5 hindurchgeführten Golddrähten mit den entsprechenden Leiterbahnen der Leiterbahnstruktur 4 verbunden bzw. kontaktiert. Der Halbleiterchip 3 und dessen Kontaktverbindungen 6 bzw. 4 werden mit einem Tropfen aus aushärtbarem Kunststoff vergossen. Auf diese Weise wird die kalottenförmige Abdeckung 1 bzw. Schutzschicht gebildet. Vor dem Vergießen wird das Kunststoff-Trägerband 5 mit einem Fließstopp 2 für die Vergußmasse versehen. Als Vergußmasse wird beispielsweise ein UV-härtbares Epoxidharz verwendet. Der Fließstopp 2 umschließt den Halbleiterchip 3 mit seinen Kontaktverbindungen 6 und den diesen zugeordneten Leiterbahnen der Leiterbahnstruktur 4 ring- bzw. kreisförmig. Der Fließstopp 2 ist in diesem bevorzugten Ausführungsbeispiel als grabenförmige Vertiefung in das Kunststoff-Trägerband 5 mittels Laserstrahlung eingebracht. Mit diesem durch Laserabbrand in das Kunststoff-Trägerband 5 als Fließstopp 2 eingebrachten Ringgraben wird die Kalottenform der Abdeckung 1 und deren Reproduzierbarkeit gewährleistet, so daß dieser Chipmodul zum formschlüssigen und damit fest verankerten Einbau in Chip- bzw. Wertkarten besonders geeignet ist.

**Patentansprüche**

1. Verfahren zum Abdecken eines kontaktierten und auf einem mit einer Leiterbahnstruktur versehenen Kunststoffträgerband befestigten Halbleiterchips, bei dem der Halbleiterchip mit seinen Kontaktverbindungen mit einem Tropfen aus aushärtbarem Kunststoff kalottenförmig vergossen wird, **dadurch gekennzeichnet**, daß das Kunststoffträgerband (5) vor dem Vergießen mit einem den Halbleiterchip (3) und dessen Kontaktverbindungen (6) ringförmig umschließenden Fließstopp (2) versehen wird.

2. Verfahren nach Anspruch 1, **dadurch gekennzeichnet**, daß der Fließstopp (2) durch Laserabbrand gebildet wird.

3. Verfahren nach Anspruch 1 oder 2, **dadurch gekennzeichnet**, daß als Fließstopp (2) eine ringförmige Vertiefung in das Kunststoffträgerband (5) eingebracht wird.

4. Verfahren nach Anspruch 3, **dadurch gekennzeichnet**, daß die ringförmige Vertiefung mittels Laserstrahlung in das Kunststoffträgerband (5) eingebracht wird.

5. Verfahren nach einem der Ansprüche 1 bis 4, **dadurch gekennzeichnet**, daß als Material für das Kunststoffträgerband (5) ein Polyester verwendet wird.

6. Verfahren nach einem der Ansprüche 1 bis 5, **gekennzeichnet durch** seine Verwendung zum Herstellen von Chipmodulen für Chipkarten.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | PATENT ABSTRACTS OF JAPAN vol. 10, no. 386 (E-467) 24 Dezember 1986, & JP-A-61 176143 (TOSHIBA CORP.) 07 August 1986, * das ganze Dokument * — — — | 1-6 | H 01 L 23/31 H 01 L 23/495 |
| X,Y | US-A-4 143 456 (CITIZEN WATCH CO LTD) * Spalte 2, Zeile 17 - Spalte 4, Zeile 3; Figuren 2b, 4 * — — — | 1,2-5 | |
| Y | FR-A-2 548 857 (CABLES CORTAILLOD SA.) * das ganze Dokument * — — — | 1,6 | |
| X | GB-A-2 003 321 (CITIZEN WATCH CO LTD) * Seite 1, rechte Spalte, Zeilen 74 - 97; Figur 4 * * Seite 2, rechte Spalte, Zeile 41 - Seite 3, rechte Spalte, Zeile 27 * — — — | 1 | |
| X | CH-A-619 333 (FASELEC AG) * Seite 1, linke Spalte, Zeilen 43 - 60 * * Seite 2, rechte Spalte, Zeile 41 - Seite 3, rechte Spalte, Zeile 27; Figur 1 * — — — | 1 | |
| Y | PATENT ABSTRACTS OF JAPAN vol. 11, no. 083 (E-489) 13 März 1987, & JP-A-61 237454 (TOSHIBA CORP.) 22 Oktober 1986, * das ganze Dokument * — — — | 1 | **RECHERCHIERTE SACHGEBIETE (Int. Cl.5)** H 01 L |
| Y | PATENT ABSTRACTS OF JAPAN vol. 7, no. 045 (E-160) 23 Februar 1983, & JP-A-57 196537 (SHIN NIPPON DENKI KK) 02 Dezember 1982, * das ganze Dokument * — — — | 1 | |
| A | PATENT ABSTRACTS OF JAPAN vol. 14, no. 156 (E-0908) 26 März 1990, & JP-A-02 014555 (HITACHI LTD) 18 Januar 1990, * das ganze Dokument * — — — — — | 1,2 | |

Der vorliegende Recherchenbericht wurde für alle Patentansprüche erstellt

| Recherchenort | Abschlußdatum der Recherche | Prüfer |
|---|---|---|
| The Hague | 16 April 91 | ZEISLER P.W. |